# EUROPÄISCHE PATENTSCHRIFT

(11) **EP 0 364 448 B1**
(45) Veröffentlichungstag und Bekanntmachung des Hinweises auf die Patenterteilung: **13.01.1993**
(21) Anmeldenummer: 88902790.0
(22) Anmeldetag: 23.03.1988
(51) Int. Cl.: H01L 27/14, G02B 6/12

(54) **MONOLITHISCH INTEGRIERTE WELLENLEITER-FOTODIODEN-FET-KOMBINATION**
MONOLITHIC INTEGRATED WAVEGUIDE-PHOTODIODE-FET COMBINATION
GUIDES D'ONDES-PHOTODIODES-FET COMBINES MONOLITHIQUES INTEGRES

(30) Priorität: 07.04.1987 DE 3711617
(43) Veröffentlichungstag der Anmeldung: 25.04.1990
(73) Patentinhaber: SIEMENS AKTIENGESELLSCHAFT, 80333 München (DE)
(72) Erfinder: TROMMER, Reiner, D-8000 München 83 (DE); ALBRECHT, Helmut, D-8000 München 70 (DE)
(86) Internationale Anmeldenummer: DE8800184
(87) Internationale Veröffentlichungsnummer: WO8808205

(56) Entgegenhaltungen:
- EP-A- 0 133 709
- EP-A- 0 272 372
- Electronics Letters, Band 23, Nr. 1, Januar 1987, (Hitchin, Herts, GB) C. Bornholdt et al.: "Waveguide-integrated PIN photodiode on InP", Seiten 2-4, siehe Seiten 2,3: "Device design and fabrication"
- EDN Electrical Design News, Band 19, Nr. 10, 20. Mai 1974, (US) E. Vodovoz: "Optical IC's: a coming technology", Seiten 20, 21
- Patent Abstracts of Japan, Band 11, Nr. 20 (E-472)(2467), 20 January 1987 & JP A 61191065
- IEEE Journal of Quantum Electronics, volume QE-22, No. 6, June 1986 (New York, US), O. Wada et al.: "Recent progress in opto-electronic integrated circuits (OEIC's)" pages 805-821

## Beschreibung

Die vorliegende Erfindung betrifft eine monolithisch integrierte Fotodioden-FET-Kombination zum Einbau in optische Nachrichtensysteme nach dem Oberbegriff des Anspruches 1.

Die Entwicklung optischer Datenübertragungssysteme geht dahin, für die Verbindung zwischen optischen und elektronischen Komponenten integrierte opto-elektronische Schaltkreise einzusetzen. Auf der Empfängerseite stellt sich das Problem der monolithischen Integration von Lichtwellenleitern, Fotodetektoren und Vorverstärker in einem Bauelement. Gefordert werden gute Kompatibilität der für die verschiedenen Komponenten benötigten Halbleiterschichten und Technologien sowie ein guter Kopplungswirkungsgrad zwischen Wellenleiter und Fotodetektor. Geschlossene Konzepte zur Integration von Lichtwellenleiter, Fotodetektor und Transistor sind nicht bekannt. Für die Wellenleiter-Fotodioden -Kombination sind bisher im wesentlichen drei Konzepte vorgeschlagen worden.

Die Auskopplung der Strahlung in die Fotodiode erfolgt bei dem ersten dieser Konzepte durch eine geeignete Umlenkung der Strahlrichtung in die Fotodiode. Die Realisierung einer derartigen Anordnung ist z.B. in der Druckschrift D.B. Ostrowsky e.a.: "Integrated optical photodetector", Appl. Phys. Lett. 22, 463-464 (1973) beschrieben. Davon abweichende Aufbauten von Wellenleiter-Fotodioden-Kombinationen, bei denen die Strahlung aus dem Wellenleiter durch Umlenken ausgekoppelt wird, sind in den Patentanmeldungen EP-A-0 187 198 und EP-A-0 192 850 beschrieben.

Eine zweite Möglichkeit der Strahlungsauskopplung besteht in der Leckwellenkopplung, die z.B. bei dem in der Druckschrift C. Bornholdt e. a.: "Waveguide-integrated PIN photodiode on InP", Electr. Lett. 23, 2-3 (1987) angegebenen Aufbau realisiert ist.
Das dritte Konzept sieht Stoßkopplung vor. Eine Ausführung hierzu findet man in der Druckschrift G.E. Stillman e.a.: "Monolithic integrated InₓGa₁₋ₓAs Schottky-barrier waveguide photodetector", Appl. Phys. Lett. 25, 36-38 (1974).

Zur Integration von Fododetektor und Feldeffekttransistor sind eine Reihe von Konzepten veröffentlicht, die in der Übersichtsarbeit 0. Wada, IEEE J. Quantum Electr. QE-22, 805-821 (1986) beschrieben sind und die in obenbegriff des Anspruchs 1 aufgefühnten Merkmale aufweisen (vgl. Figur 22). Der Grund für die verschiedenen Konsepte zur Integration von Fotodetecktor und Feldeffekttransistor liegt in den unterschiedlichen physikalischen Eigenschaften dieser Bauelemente, und zwar am unterschiedlichen Aufbau der Halbleiterschichten in Geometrie und Dotierung. Um trotzdem einen planaren Chipaufbau zu ermöglichen, sind vergrabene Fotodetektor-und/oder FET-Strukturen vorgeschlagen worden. Als FET-Strukturen kommen dabei Sperrschichtfeldeffekttransistoren (JFET), Metall-Halbleiter-Feldeffekttransistoren (MESFET) und Metall-Isolator-Halbleiter-Feldeffekttransistoren (MISFET) in Betracht.

Aus der älteren europäischen Patentammeldung EP-A-0 272 372, die unter Antikel 54(3) EP ü fällt, ist bereits eine monolithisch integrierte Wellenleister/PIN-Fotodiodem/FET-kombination bekannt, bei der sich die Deckschicht nicht über die Wellenleiterschicht und der p-datierte 2. Bereich nicht in die Fotodioden schicht erstrecken.

Aufgabe der vorliegenden Erfindung ist es, einen möglichst einfach herstellbaren Schichtaufbau für die monolithische Integration von Wellenleiter, Fotodetektor und Transistor in einem gemeinsamen Bauteil mit hoher Effektivität anzugeben.

Diese Aufgabe wird bei einer erfindungsgemäßen Anordnung durch die Merkmale des Anspruchs 1 gelöst.

Die Halbleiterschichtstruktur für ein erfindungsgemäßes Bauelement besteht aus einem Trägersubstrat - vorzugsweise semiisolierendes InP - , auf das in den für Wellenleiter, Fotodiode bzw. FET vorgesehenen Bereichen durch Lokalepitaxie eine schwach n-leitend dotierte Wellenleiterschicht - vorzugsweise (In,Ga) (As,P) oder (In,Ga,Al) As - sowie eine schwach n-leitend dotierte Fotodioden-/FET-Schicht - vorzugsweise (In,Ga) As - , die als Absorptionsschicht für die Fotodiode und als Kanalschicht für den Feldeffekttransistor dient, aufgebracht sind. Eine geschlossene schwach n-leitend dotierte Deckschicht - vorzugsweise InP oder (In,Al) As - dient als Mantelschicht für den Wellenleiter und als passivierende Schicht für die Fotodiode und den Feldeffekttransistor.

Der Wellenleiter kann dabei z.B in Streifenform ausgeführt sein. Im Bereich der Stoßstelle zwischen Wellenleiter- und Absorptionsschicht ist durch p⁺-Diffusion oder p⁺-Implantation der p-Bereich der Fotodiode ausgebildet. Das aus dem Wellenleiter austretende Licht wird in der Fotodiodenschicht absorbiert und erzeugt den Fotostrom. Der n-Kontakt der Fotodiode ist über einem ersten n-Bereich seitlich angebracht. Ein zweiter n-Bereich der Fotodiode, der sich unmittelbar unter der Fotodiodenschicht im Trägersubstrat befindet und stark n-leitend dotiert ist, hält den Serienwiderstand der Fotodiode klein.

Der Vorteil der Stoßkopplung liegt vor allem in einem guten Kopplungswirkungsgrad und einer kleinen Diodenfläche.

Der Feldeffekttransistor ist durch einen Trennbereich, der grabenförmig ausgeätzt oder durch Isolationsimplantation ausgebildet ist, von der Fotodiode getrennt. In dem Kanalbereich ist z.B. durch Ionenimplantation das für den FET benötigte Dotierungsprofil eingestellt. Das streifenförmige Gate, bestehend aus Gate-Bereich im Halbleiter und aufgebrachtem Gate-Kontakt, ist als Junction-Gate mit p⁺-Diffusion oder p⁺-Implantation oder als Schottky-Gate ausgebildet. Source- und Drain-Bereich sind stark n-leitend dotiert und mit Source-Kontakt bzw. Drain-Kontakt versehen. Die Ausbildung des FET kann einer der üblichen Ausgestaltungen entsprechen.

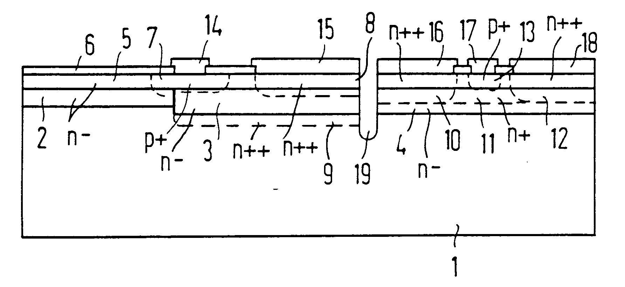

Es folgt die Beschreibung des in Figur 1 im Querschnitt dargestellten Ausführungsbeispiels.

Auf dem Trägersubstrat 1 aus InP-Material, das z.B. mit Eisendotierung semiisolierend gemacht wurde, ist eine Wellenleiterschicht, die aus schwach n-leitend dotiertem Halbleitermaterial - z. B. In_{0,9} Ga_{0,1} As_{0,8} P_{0,2} - besteht und in der Regel streifenförmig ausgebildet ist, epitaktisch aufgewachsen und durch Ätzen strukturiert. Daran angrenzend ist eine ebenfalls schwach n-leitend dotierte Halbleiterschicht - z.B. In_{0,53} Ga_{0,47} As-Material - als Fotodiodenschicht 3 und als FET-Schicht 4 epitaktisch aufgewachsen. Die Wellenleiterschicht 2 grenzt unmittelbar an die Fotodiodenschicht 3 an. Wellenleiterschicht 2, Fotodiodenschicht 3 und FET-Schicht 4 bilden zusammen eine ebene Oberfläche, die mit einer Deckschicht 5, die in dem vorliegenden Ausführungsbeispiel InP-Material ist, abgedeckt ist.

In der Deckschicht 5 über der Fotodiodenschicht 3 sind ein stark p-leitend dotierter sowie ein sehr stark n-leitend dotierter Bereich, die den p-Bereich 7 der Fotodiode bzw. den ersten n-Bereich 8 der Fotodiode bilden, ausgebildet. Dieser p-Bereich 7 und erste n-Bereich 8 sind bis zur Oberfläche der Deckschicht 5 und bis in die Fotodiodenschicht 3 ausgebildet. Auf der Oberfläche sind p-Kontakt 14 und n-Kontakt 15 aufgebracht.

Unmittelbar unter der Fotodiodenschicht 3 und sich über deren gesamte Länge erstreckend ist in dem Trägersubstrat 1 ein zweiter n-Bereich 9 der Fotodiode, der sehr stark n-leitend dotiert ist, ausgebildet, wodurch der Serienwiderstand der Fotodiode herabgesetzt wird.

In entsprechender Weise sind in der Deckschicht 5 über der FET-Schicht 4 der sehr stark n-leitend dotierte Source-Bereich 10 und der sehr stark n-leitend dotierte Drain-Bereich 12 ausgebildet, die jeweils an die Oberfläche der Deckschicht 5 reichen und möglichst weit bis in die FET-Schicht hinein ausgebildet sind. Auf der Oberfläche sind die entsprechenden Kontakte, der Source-Kontakt 16 und der Drain-Kontakt 18, aufgebracht. Zwischen dem Source-Bereich 10 und dem Drain-Bereich 12 ist ein stark n-leitend dotierter Kanalbereich 11 ausgebildet, dessen Abmessung und Dotierungsprofil den zu erzielenen physikalischen Eigenschaften des Transistors entsprechend gewählt sind. In der Deckschicht 5 ist bei Ausbildung eines Junction-Gate ein entsprechender Gatebereich 13, der stark p-leitend dotiert ist, ausgebildet. Im Falle der Verwendung eines Schottky-Kontaktes ist dieser Gatebereich 13 n-leitend dotiert. Der Gatebereich 13, der in der Dechschicht 5 bis zur Oberfläche ausgebildet ist, ist auf dieser Oberfläche mit dem Gatekontakt 17 versehen.

Auf der Deckschicht 5, soweit sie nicht mit Metallkontakten versehen ist, ist eine Passivierungsschicht 6 aus einem Dielektrikum aufgebracht. Als Material kommen Si₃N₄, SiO₂, Al₂O₃ oder vergleichbare Materialien in Frage. Die Fotodiode ist von dem Feldeffekttransistor durch einen Trennbereich 19 abgetrennt. Dieser Trennbereich 19 ist als ausgeätzter Graben oder als Bereich mit Isolationsimplantat ausgebildet.

Für die Herstellung eines diesem Ausführungsbeispiel entsprechenden Bauelementes können die üblichen Herstellungsverfahren, die von der Herstellung der Einzelkomponenten her bekannt sind, angewendet werden.

### Bezugszeichenliste

1 Trägersubstrat
2 Wellenleiterschicht
3 Fotodiodenschicht
4 FET-Schicht
5 Deckschicht
6 Passivierungsschicht
7 p-Bereich der Fotodiode
8 erster n-Bereich der Fotodiode
9 zweiter n-Bereich der Fotodiode
10 Source-Bereich
11 Kanalbereich
12 Drain-Bereich
13 Gate-Bereich
14 p-Kontakt
15 n-Kontakt
16 Source-Kontakt
17 Gate-Kontakt
18 Drain-Kontakt
19 Trennbereich

## Patentansprüche

1. Monolithisch integrierte Fotodioden-FET-Kombination mit
- einem Trägersubstrat (1) aus III-V-Halbleitermaterial,
- einer Fotodiodenschicht (3) aus Halbleitermaterial,
- einer FET-Schicht (4) aus Halbleitermaterial,
- einem für elektrische Leitung eines ersten Leitungstyps dotierten ersten Bereich (8) der Fotodiode,
- einem für elektrische Leitung eines zweiten, entgegengesetzten Leitungstyps dotierten zweiten Bereich (7) der Fotodiode,
- einem Source-Bereich (10),
- einem Kanalbereich (11),
- einem Drain-Bereich (12),
- einem Gate-Bereich (13),
- einem ersten Kontakt (14) auf dem zweiten Bereich (7) der Fotodiode,
- einem zweiten Kontakt (15) auf dem ersten Bereich (8) der Fotodiode,
- einem Source-Kontakt (16) auf dem Source-Bereich (10),
- einem Drain-Kontakt (18) auf dem Drain-Bereich (12) und
- einem Gate-Kontakt (17) auf dem Gate-Bereich (13),
**dadurch gekennzeichnet**,
- daß eine Wellenleiterschicht (2) aus Halbleitermaterial vorgesehen ist,
- daß diese Wellenleiterschicht (2), die Fotodiodenschicht (3) und die FET-Schicht (4) nebeneinander positioniert auf dem Trägersubstrat (1) aufgewachsen sind, wobei die Wellenleiterschicht (2) und die Fotodiodenschicht (3) aneinanderstoßen,
- daß die Wellenleiterschicht (2), die Fotodiodenschicht (3) und die FET-Schicht (4) schwach (n⁻) dotiert sind für elektrische Leitung des ersten Leitungstyps,
- daß die Wellenleiterschicht (2), die Fotodiodenschicht (3) und die FET-Schicht (4) eine ebene Oberfläche bilden,
- daß auf dieser ebenen Oberfläche eine Deckschicht (5) aus Halbleitermaterial aufgewachsen ist,
- daß in dieser Deckschicht (5) über der Fotodiodenschicht (3) sich in die Fotodiodenschicht (3) hinein erstreckend der zweite Bereich (7) der Fotodiode und sich ebenfalls in die Fotodiodenschicht (3) hinein erstreckend der erste Bereich (8) der Fotodiode ausgebildet sind,
- daß an die Fotodiodenschicht (3) angrenzend und sich über deren gesamte Länge erstreckend im Trägersubstrat (1) ein für elektrische Leitung des ersten Leitungstyps dotierter dritter Bereich (9) der Fotodiode ausgebildet ist,
- daß der zweite Bereich (7) der Fotodiode stank (p⁺) dotiert ist,
- daß der erste Bereich (8) der Fotodiode und der dritte Bereich (9) der Fotodiode sehr stark (n⁺⁺) dotiert sind,
- daß in der Deckschicht (5) über der FET-Schicht (4) jeweils sich in die FET-Schicht (4) hinein erstreckend und sehr stark (n⁺⁺) für elektrische Leitung des ersten Leitungstyps dotiert der Source-Bereich (10) und der Drain-Bereich (12) ausgebildet sind,
- daß in der Deckschicht (5) der sich gegebenenfalls in die FET-Schicht (4) hinein erstreckende, stark (n⁺) für elektrische Leitung des ersten Leitungstyps dotierte Kanalbereich (11) und der Gate-Bereich (13) ausgebildet sind,
- daß Fotodiode und FET durch einen Trennbereich (19) voneinander getrennt sind und
- daß der nicht mit Kontakten versehene Anteil der Oberfläche der Deckschicht (5) mit einer Passivierungsschicht (6) abgedeckt ist.

2. Monolithisch integrierte Fotodioden-FET-Kombination nach Anspruch 1,
**dadurch gekennzeichnet**,
daß der erste Leitungstyp n-Leitung und der zweite Leitungstyp p-Leitung ist.

3. Monolithisch integrierte Fotodioden-FET-Kombination nach einem der Ansprüche 1 oder 2,
**dadurch gekennzeichnet**,
daß der Gate-Bereich (13) stark P⁺ für elektrische Leitung des zweiten Leitungstyps dotiert ist und daß das Gate als Junction-Gate ausgebildet ist.

4. Monolithisch integrierte Fotodioden-FET-Kombination nach Anspruch 1 oder 2,
**dadurch gekennzeichnet**,
daß der Gate-Bereich (13) schwach für elektrische Leitung des ersten Leitungstyps dotiert ist und daß der Gate-Kontakt (17) als Schottky-Kontakt aufgebracht ist.

5. Monolithisch integrierte Fotodioden-FET-Kombination nach einem der Ansprüche 1 bis 4,
**dadurch gekennzeichnet**,
daß die Passivierungsschicht (6) Si₃N₄, SiO₂ oder Al₂O₃ enthält.

6. Monolithisch integrierte Fotodioden-FET-Kombination nach einem der Ansprüche 1 bis 5,
**dadurch gekennzeichnet**,
daß das Trägersubstrat (1) semiisolierendes InP-Material ist, daß die Fotodiodenschicht (3) und die FET-Schicht (4) InGaAs-Material sind und
daß die Deckschicht (5) InP-Material oder (In,Al)As-Material ist.

7. Monolithisch integrierte Fotodioden-FET-Kombination nach Anspruch 6,
**dadurch gekennzeichnet**,
daß die Wellenleiterschicht (2) (In,Ga)(As,P)-Material oder (In,Ga,Al)As-Material ist und die Fotodiodenschicht (3) und die FET-Schicht (4) In_{0,53}Ga₀,₄₇As-Material sind.

8. Monolithisch integrierte Fotodioden-FET-Kombination nach einem der Ansprüche 1 bis 7,
**dadurch gekennzeichnet,**
daß der Trennbereich (19) mit Isolationsimplantat ausgebildet ist.

## Claims

1. Monolithically integrated photodiode/FET combination comprising
- a carrier substrate (1) composed of III-V semiconductor material,
- a photodiode layer (3) composed of semiconductor material,
- an FET layer (4) composed of semiconductor material,
- a first photodiode zone (8) doped for electrical conduction of a first conduction type,
- a second photodiode zone (7) doped for electrical conduction of a second, opposite conduction type,
- a source zone (10),
- a channel zone (11),
- a drain zone (12),
- a gate zone (13),
- a first contact (14) on the second zone (7) of the photodiode,
- a second co.ntact (15) on the first zone (8) of the photodiode,
- a source contact (16) on the source zone (10),
- a drain contact (18) on the drain zone (12), and
- a gate contact (17) on the gate zone (13),
characterised
- in that a waveguide layer (2) composed of semiconductor material is provided ,
- in that said waveguide layer (2), the photodiode layer (3) and the FET layer (4) have been grown in adjacent positions on the carrier substrate (1), the waveguide layer (2) and the photodiode layer (3) adjoining one another,
- in that the waveguide layer (2), the photodiode layer (3) and the FET layer (4) are lightly (n⁻) doped for electrical conduction of the first conduction type,
- in that the waveguide layer (2), the photodiode layer (3) and the FET layer (4) form a flat surface,
- in that a covering layer composed of semiconductor material has been grown on said flat surface,
- in that there have been formed in said covering layer (5) above the photodiode layer (3), so as to extend into the photodiode layer (3), the second photodiode zone (7) and the first photodiode zone (8), also so as to extend into the photodiode layer (3),
- in that a third photodiode zone (9), doped for electrical conduction of the first conduction type, has been formed adjacent to the photodiode layer (3) and extending over the entire length of the latter in the carrier substrate (1),
- in that the second photodiode zone (7) is heavily (p⁺) doped,
- in that the first photodiode zone (8) and the third photodiode zone (9) are very heavily (n⁺⁺) doped,
- in that there have been formed in the covering layer (5) above the FET layer (4) the source zone (10) and the drain zone (12), each extending into the FET layer (4) and being very heavily (n⁺⁺) doped for electrical conduction of the first conduction type,
- in that there have been formed in the covering layer (5) the channel zone (11), which optionally extends into the FET layer (4) and is heavily (n⁺⁺) doped for electrical conduction of the first conduction type, and the gate zone (13),
- in that photodiode and FET are isolated from one another by an isolating zone (19), and
- in that the portion of the surface of the covering layer (5) not provided with contacts is covered with a passivating layer (6).

2. Monolithically integrated photodiode/FET combination according to Claim 1, characterised in that the first conduction type is n-type conduction and the second conduction type is p-type conduction.

3. Monolithically integrated photodiode/FET combination according to either Claim 1 or 2, characterised in that the gate zone (13) is heavily (p⁺) doped for electrical conduction of the second conduction type and in that the gate is formed as a junction gate.

4. Monolithically integrated photodiode/FET combination according to Claim 1 or 2, characterised in that the gate zone (13) is lightly doped for electrical conduction of the first conduction type and in that the gate contact (17) has been deposited as a Schottky contact.

5. Monolithically integrated photodiode /FET combination according to one of Claims 1 to 4, characterised in that the passivating layer (6) contains Si₃N₄, SiO₂ or Al₂O₃.

6. Monolithically integrated photodiode/FET combination according to one of Claims 1 to 5, characterised in that the carrier substrate (1) is semi-insulating InP material, in that the photodiode layer (3) and the FET layer (4) are InGaAs material and in that the covering layer (5) is InP arterial or (In,Al)As material.

7. Monolithically integrated photodiode/FET combination according to Claim 6, characterised in that the waveguide layer (2) is (In,Ga) (As,P) material or (In,Ga,Al)As material and the photodiode layer (3) and the FET layer (4) are IN_{0.53}Ga_{0.47}As material.

8. Monolithically integrated photodiode/FET combination according to one of Claims 1 to 7, characterised in that the isolating zone (19) is formed with implanted insulating material.

## Revendications

1. Combinaison photodiode - transistor à effet de champ en circuit intégré monolithique à semiconducteur avec :
- un substrat de support (1) en un matériau semiconducteur,
- une couche de photodiode (3) en un matériau semiconducteur,
- une couche de transistor à effet de champ (4) en un matériau semiconducteur,
- une première zone de photodiode (8) dopée pour une conduction électrique de premier type de conductivité,
- une seconde zone de photodiode (7) dopée pour une conduction électrique de second type, inverse de conductivité,
- une zone source (10),
- une zone de canal (11),
- une zone drain (12),
- une zone grille (13),
- un premier contact (14) sur la seconde zone (7) de la photodiode,
- un second contact (15) sur la première zone (8) de la photodiode,
- un contact source (16) sur la zone source (10),
- un contact drain (18) sur la zone drain (12), et
- un contact grille (17) sur la zone grille (13), caractérisée par le fait
- qu'une couche de guide d'onde (2) en un matériau semiconducteur est prévue,
- que la croissance de cette couche de guide d'onde (2), de la couche de la photodiode (3) et de la couche du transistor à effet de champ (4) est opérée de manière que ces couches soient positionnées les unes à côté des autres sur le substrat de support (1), la couche de guide d'onde (2) et la couche de la photodiode (3) étant en about.
- que la couche de guide d'onde (2), la couche de la photodiode (3) et la couche du transistor à effet de champ (4) sont dopées faiblement (n⁻) pour la conduction électrique du premier type de conductivité,
- que la couche de guide d'onde (2), la couche de la photodiode (3) et la couche du transistor à effet de champ (4) forment une surface plane,
- que sur cette surface plane, est déposée par croissance une couche de couverture (5) en un matériau semiconducteur,
- que dans cette couche de couverture (5), au-dessus de la couche de la photodiode (3), et s'étendant dans la couche de la photodiode (3) est formée la seconde zone de la photodiode (7), alors que la première zone de la photodiode (8) s'étend également dans la couche de la photodiode (3)
- que la troisième zone dopée de la photodiode (9), pour une conduction électrique du premier type de conductivité, est, dans le substrat de support (1), formée de manière contigüe à, et s'étendant tout le long de la couche de la photodiode (3),
- que la seconde zone de la photodiode (7) est fortement dopée (p⁺),
- que la première zone (8) et la troisième zone (9) de la photodiode sont fortement dopées (n⁺⁺),
- que la zone source (10) et la zone drain (12) sont chacune formées dans la couche de couverture (5) au-dessus de la couche du transistor à effet de champ (4) en s'étendant dans cette dernière couche et en étant chacune très fortement dopées (n⁺⁺) pour une conduction électrique du premier type de conductivité,
- que sont formées dans la couche de couverture (5), la zone de canal (11) qui s'étend éventuellement dans la couche du transistor à effet de champ (4) et qui est fortement dopée (n⁺) pour une conduction électrique du premier type de conductivité, ainsi que la zone de grille (13).
- que la photodiode et le transistor à effet de champ, sont séparés l'un de l'autre, par une zone de séparation (19), et
- que la partie de la surface de la couche de couverture dépourvue de contacts est recouverte par une couche de passivation (6).

2. Combinaison photodiode - transistor à effet de champ en circuit intégré monolithique à semiconducteur selon la revendication 1,
caractérisée par le fait que
le premier type de conductivité est une conduction du type n et le second type de conductivité est une conduction du type p.

3. Combinaison photodiode - transistor à effet de champ en circuit intégré monolithique à semiconducteur selon les revendications 1 ou 2,
caractérisée par le fait que
la zone grille (13) est fortement dopée (p⁺) pour une conduction du second type de conductivité et que la grille est formée comme jonction-grille.

4. Combinaison photodiode - transistor à effet de champ en circuit intégré monolithique à semiconducteur selon les revendications 1 ou 2,
caractérisée par le fait que
la zone grille (13) est faiblement dopée pour une conduction électrique du premier type de conductivité et le contact de grille (17) est déposé comme jonction de Schottky.

5. Combinaison photodiode - transistor à effet de champ en circuit intégré monolithique à semiconducteur selon les revendications 1 à 4,
caractérisée par le fait que
la couche de passivation (6) comporte du Si₃N₄, du SiO₂ ou du Al₂O₃.

6. Combinaison photodiode - transistor à effet de champ en circuit intégré monolithique à semiconducteur selon les revendications 1 à 5,
caractérisé par le fait que
le substrat de support (1) est en un matériau semi-isolant InP, que la couche de photodiode (3) et la couche du transistor à effet de champ (4) sont en un matériau contenant du InGaAs, et que la couche de couverture (5) est en un matériau contenant du InP ou du (In, Al)As.

7. Combinaison photodiode - transistor à effet de champ en circuit intégré monolithique à semiconducteur selon la revendication 6,
caractérisée par le fait que
la couche du guide d'onde (2) est en un matériau contenant du (In, Ga) (As,P) ou du (In, Ga, Al)As et que la couche de photodiode (3) et la couche du transistor à effet de champ (4) sont en un matériau contenant du In₀_{,53}Ga₀_{,47}As.

8. Combinaison photodiode - transistor à effet de champ en circuit intégré monolithique à semiconducteur selon les revendications 1 à 7,
caractérisée par le fait que
la zone de séparation (19) est réalisée avec un implant isolant.
